# EUROPEAN PATENT APPLICATION

(11) **EP 4 068 338 A1**
(43) Date of publication of application: **05.10.2022**
(21) Application number: 22164762.1
(22) Date of filing: 28.03.2022
(51) Int. Cl.: H01L 21/304, H01L 21/02, H01L 29/66, H01L 29/861

(54) **SEMICONDUCTOR MESA DEVICE FORMATION METHOD**

(30) Priority: 29.03.2021 CN 202110335748
(71) Applicant: Littelfuse Semiconductor (Wuxi) Co., Ltd., Wuxi, Jiangsu 214142 (CN)
(72) Inventor: Zeng, Jianfei, Wuxi, 214142 (CN)
(74) Representative: Arnold & Siedsma

(57) **Abstract**

A method of forming a semiconductor device may include providing a semiconductor substrate, the semiconductor substrate comprising an inner region of a first polarity, and a surface layer, disposed on the inner region, wherein the surface layer comprises a second polarity, opposite the first polarity. The method may further include removing a surface portion of the semiconductor substrate using a saw, wherein a trench region is formed within the semiconductor substrate, and cleaning the trench region using a chemical process, wherein at least one mesa structure is formed within the semiconductor substrate.

## Description

### Field

Embodiments relate to the field of semiconductor devices, and more particularly to semiconductor devices using mesa-type structures.

### Discussion of Related Art

In the present day semiconductor devices may employ mesa-type structures to form active devices. According to known approaches, a mesa structure may form electrical isolation for a semiconductor substrate that includes multiple layers of different polarity. For example, a semiconductor substrate may include an n-type region in an interior region and a p-type layer that is formed above the n-type region, toward the surface of the semiconductor substrate. To form a mesa-type device, in order to achieve electrical isolation of an area of the substrate to form the mesa, a perimeter for the mesa to be formed may be defined by lithography. For example, a photoresist layer may be deposited upon the substrate, and a mask or other means may be used to define the perimeter of the mesa within the photoresist layer. The photoresist layer may then be patterned to generate exposed regions of the substrate to be etched. A subsequent wet etch process may be performed to remove a surface portion of the substrate to define the perimeter, thus creating a mesa. The perimeter region may then be passivated for example. This approach to forming mesas may involve multiple operations, including photoresist coating, mask aligning, development, over bake, and may involve WNDR, NBA, quartz mask materials.

In view of the above considerations, improvements to the aforementioned mesa process may be useful.

With respect to these and other considerations the present disclosure is provided.

### Summary

In one embodiment, a method of forming a semiconductor device is provided. The method may include providing a semiconductor substrate, the semiconductor substrate comprising an inner region of a first polarity, and a surface layer, disposed on the inner region, wherein the surface layer comprises a second polarity, opposite the first polarity. The method may further include removing a surface portion of the semiconductor substrate using a saw, wherein a trench region is formed within the semiconductor substrate, and cleaning the trench region using a chemical process, wherein at least one mesa structure is formed within the semiconductor substrate.

In another embodiment a method of forming a semiconductor device may include providing a semiconductor substrate, the semiconductor substrate comprising an inner region of a first polarity, and a surface layer, disposed on the inner region, wherein the surface layer comprises a second polarity, opposite the first polarity. The method may also include using a saw to define a grid pattern in the semiconductor substrate, wherein the grid pattern comprises a trench region formed in an X-Y grid, wherein the trench region extends through an entirety of the surface layer, wherein a plurality of mesas are formed in the surface layer, wherein a given mesa of the plurality of mesas is electrically isolated from other mesas of the plurality of mesas.

In a further embodiment, a method of forming a semiconductor device is provided. The method may include providing a semiconductor substrate, the semiconductor substrate comprising an inner region of a first polarity, and a first surface layer, disposed on the inner region, on a first side of the semiconductor substrate, and a second surface layer, disposed on the inner region, on a second side of the semiconductor substrate, opposite the first side. As such, the first surface layer and the second surface layer may comprise a second polarity, opposite the first polarity. The method may include removing a first surface portion of the semiconductor substrate using a saw, on the first surface, and removing a second surface portion of the semiconductor substrate on the second surface, using the saw. As such, a first trench region may be formed within the semiconductor substrate on the first surface, and a second trench region may be formed within the semiconductor substrate on the second surface. The method may include cleaning the first trench region and the second trench region using a chemical process, wherein at least one mesa structure is formed within the semiconductor substrate on the first side, and at least one additional mesa structure is formed within the semiconductor substrate on the second side.

### Brief Description of the Drawings

**FIG. 1A** and **FIG. 1B** present a side cross-sectional view of a substrate, at different stages during formation of a mesa device structure, according to various embodiments of the disclosure.
**FIG. 1C** presents a top plan view of a substrate, at the stage of formation as indicated in FIG. 1B.
**FIG. 2A** and **FIG. 2B** present a side cross-sectional view of a substrate, at different stages during formation of a mesa device structure, according to various embodiments of the disclosure.
**FIG. 3** depicts an exemplary process flow.
**FIG. 4** depicts another exemplary process flow.

### Description of Embodiments

The present embodiments will now be described more fully hereinafter with reference to the accompanying drawings, in which exemplary embodiments are shown. The embodiments are not to be construed as limited to the embodiments set forth herein. Rather, these embodiments are provided so that this disclosure will be thorough and complete, and will fully convey their scope to those skilled in the art. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "either", and/or it may mean "both", although the scope of claimed subject matter is not limited in this respect.

In various embodiments methods for forming mesa type semiconductor devices including a transient voltage suppression (TVS) diode device are provided.

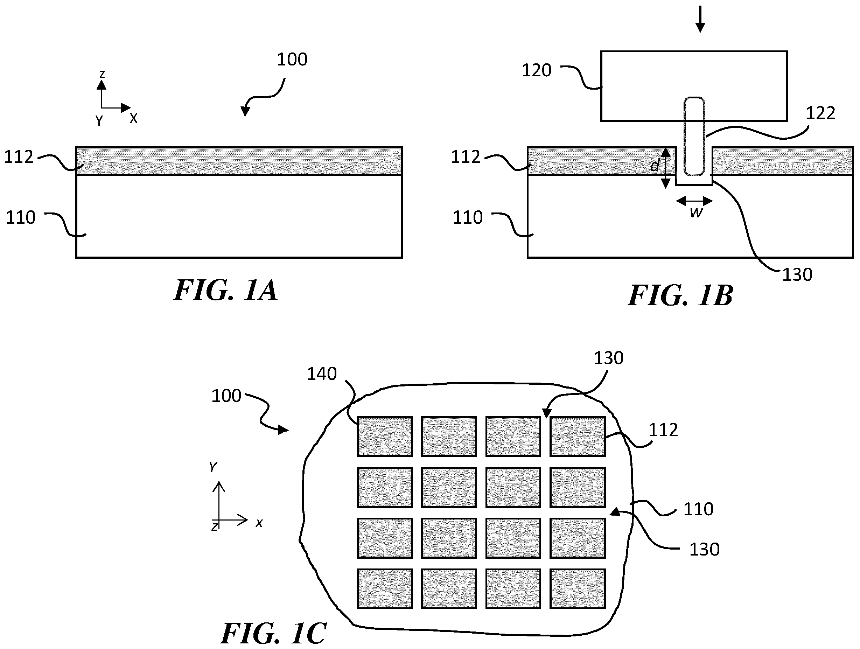

**FIG. 1A** and **FIG. 1B** present a side cross-sectional view of a substrate 100, at different stages during formation of a mesa device structure 140, according to various embodiments of the disclosure. **FIG. 1C** presents a top plan view of the substrate 100, at the stage of formation as indicated in FIG. 1B.

In FIG. 1A, the substrate 100 is shown including an inner region 110, having a first polarity. For example, the substrate 100 may be a N-type substrate, where the inner region 110 is also n-type. A surface layer 112 is disposed on the inner region 110. The surface layer 112 comprises a second polarity, opposite the first polarity of the inner region 110. For example, the surface layer 112 may be a P-type layer. The surface layer 112 may be formed using any suitable known method. The thickness and dopant concentration in surface layer 112 may be selected according to the type of device to be formed from the mesa device structure 140.

For example, in the case of TVS device, a suitable dopant concentration may be chose to generate a target breakdown voltage, such as 15 V-20 V, or 30 V-35 V, according to different non-limiting embodiments. Likewise, the thickness of the surface layer 112 may be chose to generate the desired electrical properties of a device to be formed. In some non-limiting embodiments the thickness of the surface layer 112 may be in the range of two mils.

Turning to FIG. 1B there is shown a novel operation for forming a mesa device structure, in accordance with embodiments of the disclosure. In this operation a saw apparatus 120 is employed to form a trench region 130 in a surface region of the substrate 100. The saw apparatus 120 may be a known type of saw, and may, for example, employ a cutting blade 122, formed of a metal, ceramic, carbide, diamond, or combination thereof, according to non-limiting embodiments of the disclosure. The saw apparatus 120 may be arranged to generate a trench having a controllable and fixed depth within the substrate 100.

As suggested in FIG. 1B, the formation of the trench region 130 may be used to electrically isolate a portion of the surface layer 112, in order to form a semiconductor device. In various embodiments, to achieve electrical isolation, the trench region 130 is defined by a trench depth d, wherein the trench depth d is at least as great as a thickness of the surface layer 112. For example, in some embodiments, the trench depth d may be at least two mils, while the trench width w may be on the order of several mils, such as five mils, 10 mils, or 20 mils. The embodiments are not limited in this context.

To define a mesa device structure 140, the saw apparatus 120 may be arranged to generate a two-dimensional pattern for the trench region 130, such as a grid pattern. In the example, of FIG. 1C, an array of mesa device structures 140 are shown, where these device structures form a grid of rectangular mesas, each mesa being surrounded by the trench region 130 that forms a perimeter around the given mesa device structure. Because the trench region 130 extends at least through an entirety of the surface layer 112, the surface layer 112 within a given mesa device structure is electrically isolated from the portion of the surface layer 112 within any other mesa device structure, since current must travel through the inner region 110, of opposite polarity. In the example of FIG. 1C, the trench region 130 may be formed by generating a series of saw cuts along the X-axis, and a series of saw cuts along the Y-axis, to form a grid pattern, as shown.

In accordance with embodiments of the disclosure, further operations may be performed to complete formation of a semiconductor device, including cleaning and passivation, as detailed with respect to further embodiments to follow.

An advantage of the approach shown in FIG. 1A to FIG. 1C is that mesa isolation may be accomplished essentially in one operation, involving a saw cutting process that can be programmed to generate a repeatable trench depth suitable for a given device formation.

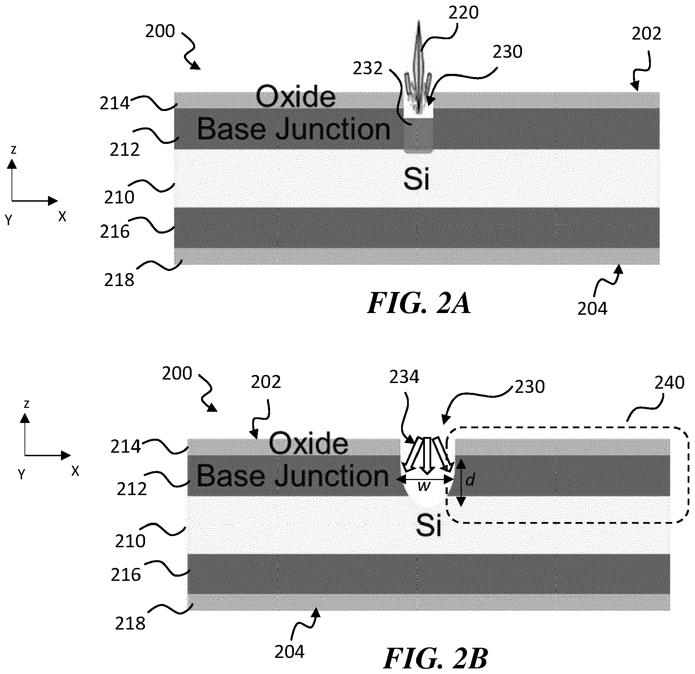

**FIG. 2A** and **FIG. 2B** present a side cross-sectional view of a substrate 200, at different stages during formation of a mesa device structure 240, according to various embodiments of the disclosure.

In FIG. 2A, the substrate 200 is shown including an inner region , the semiconductor substrate comprising an inner region 210, having a first polarity. For example, the substrate 200 may be a N-type substrate, where the inner region 210 is also n-type. Alternatively, the substrate 200 may be a P-type substrate, where the inner region 210 is also p-type. A first surface layer 212 is disposed on the inner region 210. The first surface layer 212 comprises a second polarity, opposite the first polarity of the inner region 210. For example, the first surface layer 212 may be a P-type layer. The first surface layer 212 may be formed using any suitable known method. The thickness and dopant concentration in first surface layer 212 may be selected according to the type of device to be formed from the mesa device structure 240. The substrate 200 includes a second surface layer 216, disposed on an opposite side of the inner region 210, where the second surface layer 216 comprises a second polarity, opposite the first polarity of the inner region 210. The substrate 200 further includes a first oxide layer 214, disposed over the first surface layer 212, and a second oxide layer 218, disposed over the second surface layer 216. Thus, in the embodiment specifically shown in FIGs. 2A, 2B, the substrate 200 may function as a bi-directional diode. In some non-limiting embodiments, the first surface layer 212 and the second surface layer 216 may have a same thickness and a same dopant concentration as one another, while in other embodiments the thickness and/or dopant concentration of the first surface layer 212 and second surface layer 216 may differ. For example, according to various embodiments, the first surface layer 212 and second surface layer 216, as well as the first oxide layer 214 and second oxide layer 218 may be formed in a single diffusion process to establish base junctions.

As with the embodiments of FIGs. 1A-1C, the thickness and dopant concentration of the first surface layer 212 may be chosen according to the device application of a mesa device structure to be formed.

As further depicted in FIG. 2A, there is shown a novel operation for forming a mesa device structure, in accordance with embodiments of the disclosure. In this operation a saw apparatus 220 is employed to form a trench region 230 in a surface region of the substrate 100. The saw apparatus 220 may be a known type of saw, and may, for example, employ a cutting blade (not shown), formed of a metal, ceramic, carbide, diamond, or combination thereof, according to non-limiting embodiments of the disclosure. The saw apparatus 220 may be arranged to generate a trench having a controllable and fixed depth within the substrate 200.

As suggested in FIG. 2A, the formation of the trench region 230 may be used to electrically isolate a portion of the first surface layer 212, in order to form a semiconductor device. In various embodiments, to achieve electrical isolation, the trench region 230 is defined by a trench depth d, as shown in FIG. 2B, wherein the trench depth d is at least as great as a thickness of the first surface layer 212. As with the previous embodiments, the trench depth d may be at least two mils, while the trench width w may be on the order of several mils, such as five mils, 10 mils, or 20 mils. The embodiments are not limited in this context.

To define a mesa device structure 240, the saw apparatus 220 may be arranged to generate a two-dimensional pattern for the trench region 230, such as a grid pattern, as generally described with respect to FIG. 1C. At the stage of operation of FIG. 2A, the trench region 230 has been defined by a saw cut, while debris 232, formed as a byproduct of the saw cut, may remain in the trench region 230, as well as in other surface regions of the substrate 200. The cleaning operation may be accomplished using a chemical process 234, shown schematically by the arrows. In one non-limiting embodiments, the chemical process 234 is an MAE etch (a formula for the MAE etch may be represented by a 2:1:1 mixture of (HF:HNO₃:CH₃COOH), wherein the MAE etch removes residual semiconductor debris and ion contamination in a surface of the trench region 230.

After formation of the trench region 230, shown in FIG. 2B, further operations may include the formation of a passivation layer in the trench region 230.

An advantage of the embodiment of FIGs. 2A, 2B is that formation of a mesa device structure merely entails a saw cutting operation, followed by a simple chemical etch process.

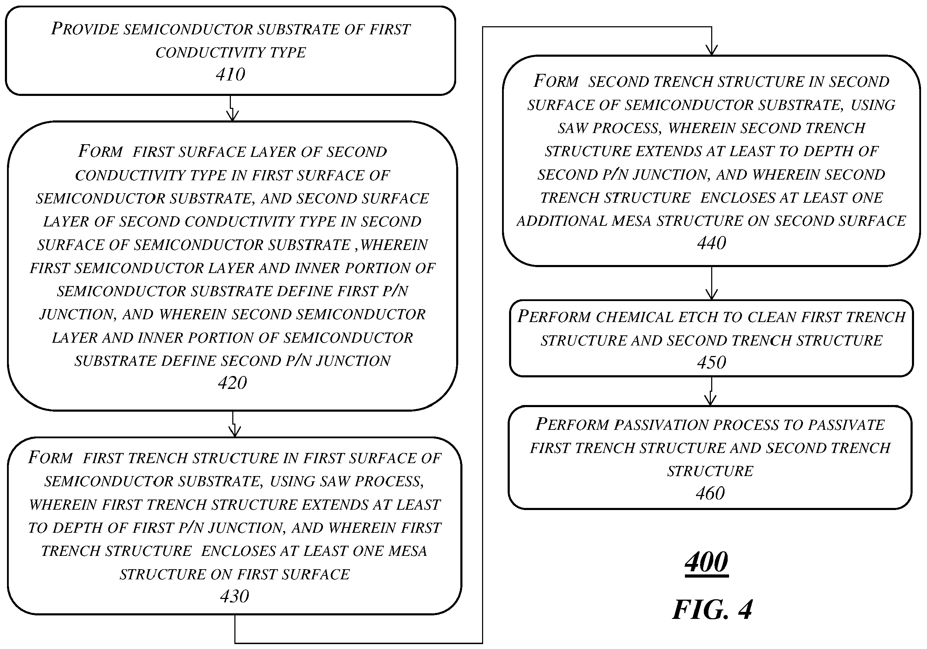

While not shown in FIG. 2B, according to various embodiments of the disclosure, when a substrate such as substrate 200 is formed as a bi-directional diode, the mesa device structure 240 may be formed on both sides of the substrate. In other words, a mesa device structure 240 may be formed both on the upper surface 202 of substrate 200, while a mesa device structure 240 is also formed (using second surface layer 216) on the lower surface 204 of substrate 200. Such a process is detailed further with respect to FIG. 4 to follow.

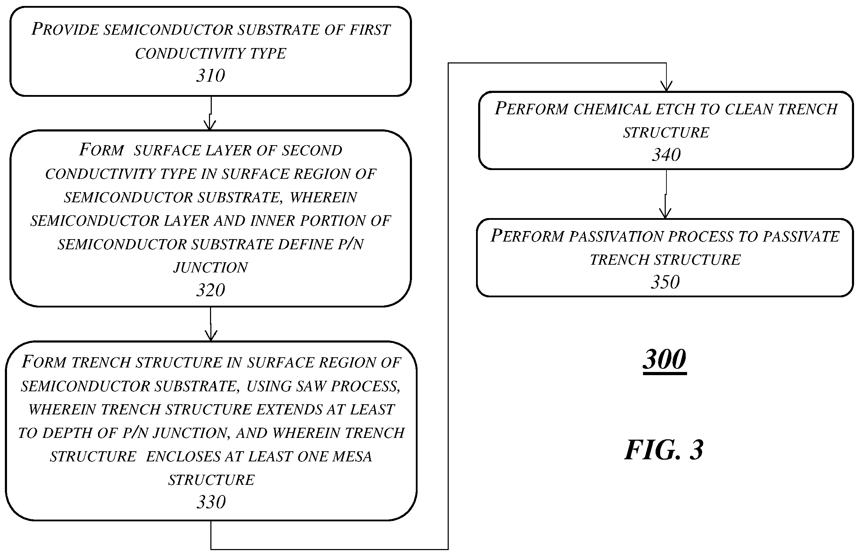

**FIG. 3** depicts a process flow 300, according to embodiments of the disclosure. At block 310, a semiconductor substrate is provided, such as a silicon substrate. In some embodiments, the semiconductor substrate may be doped as first conductivity type (first polarity) and at a suitable doping concentration for forming a device, such as a breakdown diode. As an example, the semiconductor substrate may be doped to have an N-type polarity.

At block 320, a surface layer of a second conductivity type is formed in a surface region on one main surface of the semiconductor substrate, where the surface layer and an inner portion of the semiconductor substrate define a p/n junction. For example, if the semiconductor substrate is doped to have an N-type polarity as a whole, the surface layer may be formed on the semiconductor substrate to define a P-type semiconductor layer that is disposed now over an N-type inner portion of the semiconductor substrate. In some non-limiting embodiments, a second surface layer of the second conductivity type may be formed on an opposite main surface of the semiconductor substrate. In such embodiments, a second p/n junction may be formed between the inner portion of the semiconductor substrate and the second surface layer.

At block 330, a trench structure is formed in a surface region of the semiconductor substrate, using a saw cut process, where the trench structure extends at least to the depth of the p/n junction. and wherein trench structure encloses at least one mesa structure. In particular, the saw cut process may be performed in a manner that the trench structure forms a two-dimensional perimeter that defines at least one mesa structure. In various embodiments, the saw cut process may define a two-dimensional rectangular grid that defines an array of mesa structures.

At block 340, a chemical etch process is performed, subsequently to the saw cut process, to remove debris and clean the trench structure. The chemical etch process may be any suitable etch process as known in the art, such as an MAE process.

Turning to block 350, a passivation process is performed to passivate the trench structure.

**FIG. 4** depicts another exemplary process flow 400. At block 410 a semiconductor substrate of a first conductivity type is provided.

At block 420, a first surface layer of second conductivity type is formed in a first surface of the semiconductor substrate, and a second surface layer of the second conductivity type is formed in a second surface of the semiconductor substrate. As such, the first semiconductor layer and an inner portion of the semiconductor substrate define a first p/n junction, and the second semiconductor layer and inner portion of the semiconductor substrate define a second p/n junction.

At block 430 a first trench structure is formed in the first surface of the semiconductor substrate, using a saw process, wherein the first trench structure extends at least to depth of the first p/n junction, and wherein the first trench structure encloses at least one mesa structure on the first surface.

At block 440, a second trench structure is formed in the second surface of the semiconductor substrate, using the saw process, wherein the second trench structure extends at least to depth of the second p/n junction, and wherein the second trench structure encloses at least one additional mesa structure on the second surface.

At block 450, a chemical etch is performed to clean the first trench structure and the second trench structure. The chemical etch may be any suitable etch process as known in the art, such as an MAE process.

At block 460, a passivation process is performed to passivate the first trench structure and the second trench structure. As such, a bi-directional diode device may be formed with mesa device structures on both sides of the semiconductor substrate.

While the present embodiments have been disclosed with reference to certain embodiments, numerous modifications, alterations and changes to the described embodiments are possible without departing from the sphere and scope of the present disclosure, as defined in the appended claims. Accordingly, it is intended that the present embodiments not be limited to the described embodiments, and that it has the full scope defined by the language of the following claims, and equivalents thereof.

## Claims

1. A method of forming a semiconductor device, comprising:
providing a semiconductor substrate, the semiconductor substrate comprising an inner region of a first polarity, and a surface layer, disposed on the inner region, wherein the surface layer comprises a second polarity, opposite the first polarity;
removing a surface portion of the semiconductor substrate using a saw, wherein a trench region is formed within the semiconductor substrate; and
cleaning the trench region using a chemical process, wherein at least one mesa structure is formed within the semiconductor substrate.

2. The method of claim 1, wherein the trench region comprises a trench depth, wherein the trench depth is at least as great as a thickness of the surface layer.

3. The method of claim 2, wherein the trench depth is at least two mils.

4. The method of any of the preceding claims, wherein the trench region comprises a trench width, preferably wherein the trench width is between 5 mils and 50 mils.

5. The method of any of the preceding claims, wherein the trench region is arranged in a grid pattern that defines a plurality of mesas.

6. The method of any of the preceding claims, further comprising passivating the trench region after the cleaning.

7. The method of any of the preceding claims, wherein the chemical process comprise an MAE etch, wherein the MAE etch removes residual semiconductor debris and ion contamination in a surface of the trench region.

8. The method of any of the preceding claims, wherein the semiconductor device comprises a TVS device.

9. A method of forming a semiconductor device, comprising:
providing a semiconductor substrate, the semiconductor substrate comprising an inner region of a first polarity, and a surface layer, disposed on the inner region, wherein the surface layer comprises a second polarity, opposite the first polarity; and
using a saw to define a grid pattern in the semiconductor substrate, wherein the grid pattern comprises a trench region formed in an X-Y grid, wherein the trench region extends through an entirety of the surface layer, wherein a plurality of mesas are formed in the surface layer, wherein a given mesa of the plurality of mesas is electrically isolated from other mesas of the plurality of mesas.

10. The method of claim 9,
wherein a trench depth of the trench region is at least two mils and/or wherein a trench width is between 5 mils and 50 mils.

11. The method of claim 9 or 10, further comprising:
chemically cleaning the trench region; and passivating the trench region after the chemically cleaning, preferably wherein the chemically cleaning comprises performing an MAE etch, wherein the MAE etch removes residual semiconductor debris and ion contamination in a surface of the trench region.

12. The method of any of the claims claim 9-11, wherein the semiconductor device comprises a TVS device.

13. A method of forming a semiconductor device, comprising:
providing a semiconductor substrate, the semiconductor substrate comprising an inner region of a first polarity, and a first surface layer, disposed on the inner region, on a first side of the semiconductor substrate, and a second surface layer, disposed on the inner region, on a second side of the semiconductor substrate, opposite the first side, wherein the first surface layer and the second surface layer comprise a second polarity, opposite the first polarity;
removing a first surface portion of the semiconductor substrate using a saw, on the first surface, and removing a second surface portion of the semiconductor substrate on the second surface, using the saw, wherein a first trench region is formed within the semiconductor substrate on the first surface, and a second trench region is formed within the semiconductor substrate on the second surface; and
cleaning the first trench region and the second trench region using a chemical process, wherein at least one mesa structure is formed within the semiconductor substrate on the first side, and at least one additional mesa structure is formed within the semiconductor substrate on the second side.

14. The method of claim 13, wherein the first trench region and the second trench region comprise a trench depth, wherein the trench depth is at least as great as a first thickness of the first surface layer and a second thickness of the second surface layer, preferably with one or more of the following:
wherein the first thickness equals the second thickness;
wherein the trench depth is at least two mils;
wherein a trench width is between 5 mils and 50 mils.

15. The method of any of the preceding claims, wherein the first trench region and the second trench region are arranged in a grid pattern that defines a plurality of mesas on the first surface and on the second surface.
